Europäisches Patentamt

(19) European Patent Office

Office européen des brevets

(11) Publication number: **0 011 464**

A2

# EUROPEAN PATENT APPLICATION

(12)

(21) Application number: 79302532.1

(22) Date of filing: 12.11.79

(51) Int. Cl.³: **H 03 C 1/50**
**H 03 K 7/04, H 04 B 1/04**

(30) Priority: 14.11.78 US 960677

(43) Date of publication of application:
28.05.80 Bulletin 80/11

(84) Designated Contracting States:
**BE DE FR GB IT LU NL**

(71) Applicant: CONTINENTAL ELECTRONICS MFG. CO.
P.O. Box 270879
Dallas, Texas 75227(US)

(72) Inventor: Weldon, James Oliver
5205 Park Lane
Dallas, Texas(US)

(72) Inventor: Sainton, Joseph Bryan
7225 Ferguson Road Apt 1291
Dallas, Texas 75228(US)

(74) Representative: Main, Peter Stephen et al,
HYDE, HEIDE & O'DONNELL 2 Serjeants' Inn
London EC4Y 1LL(GB)

(54) Circuit and method for generating modulated oscillations and a modulated oscillatory signal generated by the method.

(57) A pair of square wave signals at a carrier frequency are generated and the relative phase between them is varied in accordance with a modulating signal. The two variable phase square wave signals are applied to respective amplifier circuits both feeding a common output circuit. Each amplifier comprises two serially connected switching devices (24, 26 or 25, 27 ) fed with an input square wave signal in phase opposition. The serial interconnections between the switching devices of each amplifier are connected to opposite ends of the primary winding of a transformer (34) forming part of the output circuit. The secondary winding of the transformer is connected to a low-pass filter so that the resultant output is an amplitude modulated sinusoidal signal.

./...

FIG.1

- 1 -

This invention relates to electric circuit arrangements and methods for generating modulated oscillations.

In conventional modulation circuits of one type, carrier oscillations are generated and amplified for application to a final or power amplifier, and separate modulating circuits are provided and connected to the power amplifier circuits for amplitude modulating of the oscillations. Such circuits have relatively low efficiency, and also require a comparatively large number of elements of high current capacity.

In order to overcome the disadvantages of such modulation systems, much more efficient techniques are disclosed, i.e. in U.S. Patents 2,445,568, (Ferguson) and 4,118,677, (Weldon). In the arrangement of these references, variable width pulses of carrier frequency were generated for application to the final amplifier, the final amplifier being essentially in the form of a switching device. As a consequence, the high power modulation devices of conventional amplifying systems were avoided.

These arrangements, however, required the production of variable width rectangular pulses, although they were not essentially the same as the pulse width modulation techniques disclosed, i.e. in U.S. Patents 3,440,566; 3,506,920 and 3,588,744.

In the publication, "High Power Outphasing Modulation", November 1935 Proceedings of the I.R.E.,

H. Chireix describes a system wherein a pair of separate radio frequency channels having sine wave amplification derived an output at the power amplifier stage by varying the phase of the sine waves, in order to produce modulation as a result of variation of the phases of the sine waves from 180° (for 0 output), up to 90° or more, the output being combined to deliver a signal to an antenna. The system of Chireix does not, however, provide for the production of controlled energy output oscillations simply by the variation of the relative phases of waves, in accordance with the present invention.

The present invention is directed to a provision for overcoming the disadvantages of prior art arrangements for the generation of modulated oscillations.

According to the present invention, defined in Claim 1 hereof, there is provided an electronic circuit arrangement for generating modulated oscillations comprising generating means for generating two separate square wave signals at a carrier frequency, means for varying the relative phase between the said square wave signals in accordance with a modulating signal, and an output circuit coupled to receive said square wave signals and provide an output dependent on the relative phase therebetween.

The said invention includes a said circuit arrangement wherein there are two amplifier circuits for amplifying the said respective square wave signals and said output circuit is connected to both of said amplifier circuits to yield output oscillations which are amplitude modulated in dependence on the phase difference between the square waves.

The present invention also includes a method of generating modulated oscillations comprising the steps of generating two separate square wave signals at a carrier frequency, varying the relative phase between said signals in accordance with a modulating signal, and combining said signals of variable relative phase in a manner such that the resultant output signal has an amplitude which is a function of the said relative phase. Also the invention includes modulated oscillatory signals generated by any such method.

The phases of the square waves are preferably controlled in accordance with a square law, relative to the signals to be impressed upon the output carrier wave oscillations; in order to simulate without distorting, the effects obtained by conventional amplitude modulation techniques.

In certain embodiments of the invention, there are amplifier means each comprising a pair of serially connected amplifier or switching devices, the corresponding switching device being alternately controlled to conduct by their respective square wave inputs. In this arrangement, the output circuit may be connected between the junctions of the switching devices of the two amplifier circuits.

The output circuit may comprise a transformer coupled between the output terminals of two amplifier devices, and a filter network connected to the output of the transformer for converting the resultant rectangular wave output to amplitude modulated sinusoidal oscillations.

There may be antenna means coupled to a secondary winding of the said transformer to enable oscillations at the carrier frequency to be radiated.

In certain embodiments of the invention, the means for varying the relative phase between the square wave signals operates to vary the phase of one of said signals while the phase of the other of said signals is maintained constant. As an alternative, the phases of both square wave signals can be varied in dependence on a modulating signal,

- 4 -

as is also hereinafter exemplified.

In a circuit arrangement according to the invention, the means for generating two separate square wave signals at a carrier frequency and the means for varying the relative phase between the said square wave signals in accordance with a modulating signal may be combined, i.e. they may be one and the same means fulfilling such generating and relative-phase-varying functions.

The present invention furthermore includes an electronic circuit arrangement for combining square wave signals of varying relative phase and providing an output depending on such relative phase.

More specifically, the invention includes an electronic circuit arrangement for generating modulated oscillations characterised in that it comprises means for combining two separate square wave signals at a carrier frequency and of varying relative phase, and for providing an output depending on such relative phase.

Such a circuitry can be employed for combining two separate square wave signals which have been generated by (possibly remote) generating means. and which have been subjected to relative phase variation in dependence on a modulating signal.

Embodiments of the invention, selected by way of example, will now be described with reference to the accompanying drawings, wherein :

Figure 1 is a simplified circuit diagram of one embodiment of the invention;

Figures 2A to 2D are simplified time diagrams illustrating the principle of operation of the arrangement of Figure 1;

Figures 3 to 10 are oscillographs showing waves produced in a circuit embodying the invention;

Figure 11 is a block diagram of a circuit for producing square wave signals of variable phase;

Figures 12A to 12R are timing diagrams illustrating the wave forms at specific points in the circuit of Figure 11;

Figure 13 is a simplified circuit diagram relating to a further embodiment of the invention; and

Figures 14 to 21 are oscillograms illustrating further wave forms in the circuit shown in Figure 11.

Referring now to the drawings, therein is illustrated the basic elements required for a circuit for generating amplitude oscillations, in accordance with one embodiment of the invention. This circuit is illustrated as including two input transformers 10 and 11 having primary windings 12 and 13, respectively. The first transformer 10 has a pair of secondary windings 14 and 16, and the second transformer 11 has a pair of secondary windings 15 and 17. The input winding 12 is connected to an input terminal 18 by way of a series capacitor 20, and similarly an input terminal 19 is connected to the primary winding 13 by way of a capacitor 21. One end of each of the secondary windings 14 and 16 is connected to the base of transistors 24 and 26, respectively. The emitter-collector paths of these transistors are serially connected in that order between ground reference and a positive operating source terminal 28. The other end of the secondary winding 14 is connected to the junction of the collector of transistor 26 and the emitter of transistor 24, as well as to the output terminal 30. The other end of the secondary winding 16 is connected to ground reference. Similarly the windings 15 and 17 each have one end connected to the base of transistors 25 and 27 respectively with the emitter-collector paths of these transistors being connected in series between the ground reference potential and the supply terminal 28. The other end of the winding 15 is connected to the junction of the emitter-collector paths of the transistors 25 and 27 as well as to the second output terminal 31. The other end of the winding 17 is connected to ground reference.

The windings of the transformers 10 and 11 are poled so that the potential applied to the bases of the respective transistors are opposite, whereby, the voltages at the respective output terminals 30 and 31 will alternate from substantially ground reference potential to substantially the potential of the operating voltage source.

It is thus evident that, excluding the supply terminal 28, the portions of the circuit so far represented by even reference numerals form one amplifying system, and the portions of the arrangement identified by odd reference numerals correspond to a second discrete amplifying system. The output terminals of these two amplifying systems are connected to an output circuit, to produce resultant output oscillations corresponding to the difference of the potentials at the respective output terminals. For this purpose, an output transformer 34 has its primary winding connected between the terminals 30 and 31, and its secondary winding connected between a system output terminal 35 and ground reference by way of a filter network 36. In the illustrated embodiment of the invention, the filter 36 is a T-network including series inductors 37 and 38 and a shunt capacitor 39. This filter is consequently a low-pass filter. It is evident, of course, that other forms of filters may be employed serving the function of smoothing the generally square wave output of the transformer 34 to a generally sinusoidal output across a load 40, as illustrated.

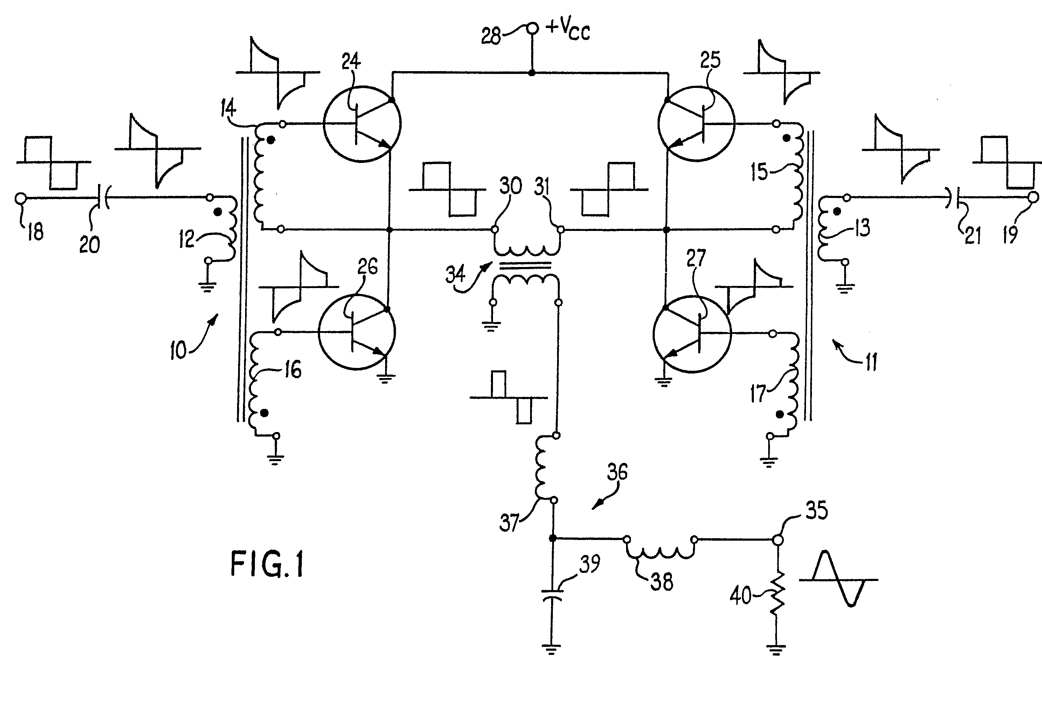

In operation of the circuit of Figure 1, square wave signals of the same freuqnecy are applied to the input terminals 18 and 19, these square wave signals being of the carrier frequency of the oscillations eventually applied to the load 40. While the load 40 has been indicated as a resistor, it is, of course, evident that this representation has been shown for illustrative purposes only and the terminal 35 may thereby be coupled by conventional means, for example, to an antenna system for radiation of waves at the above carrier frequency.

It will be understood that for achieving optimum performance by a circuit arrangement according to the invention, the square waves should have as nearly as possible a 50% duty cycle.

The general forms of the square waves, as they appear at different portions of the circuit, are sketched on the circuit of Figure 1. Thus, the coupling capacitors 20 and 21 provide a slight differentiating effect, in combination with the input windings, and the transistors of each amplifier system are alternately saturated and nonconductive. As a consequence, square wave signals are also provided at the output terminals 30 and 31.

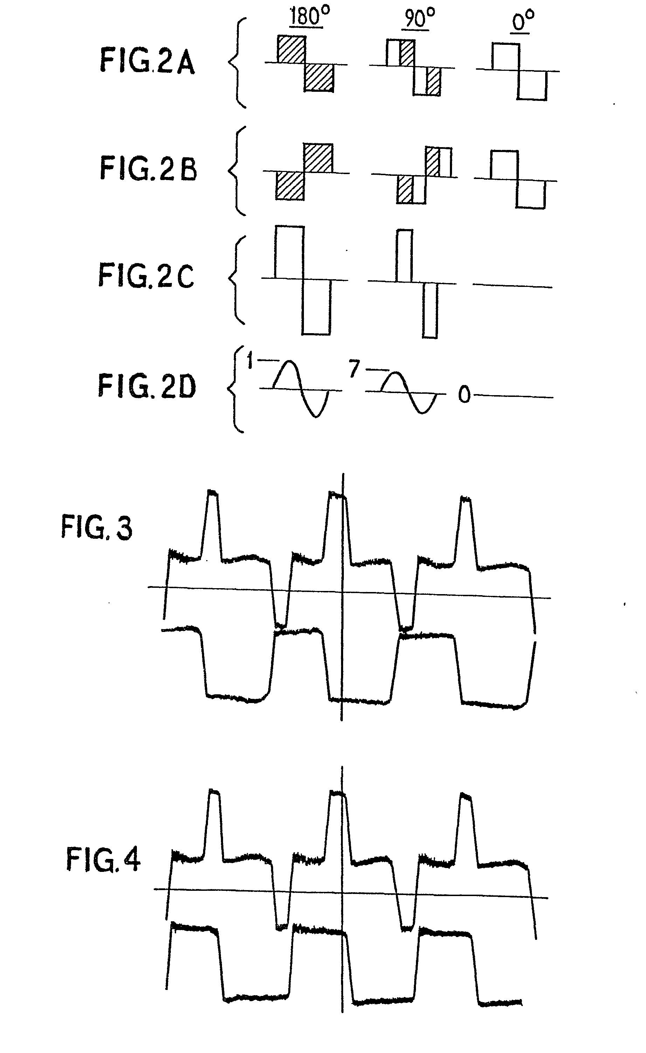

It is further evident that the wave form of the voltage at the output of the output transformer 34 will be dependent upon the phase relationship of the square wave voltages at the terminals 30 and 31. This relationship is more clearly evident by reference to Figure 2. Thus, Figures 2A and 2B each show three separate square waves, aligned to be 180$^{\circ}$ out-of-phase, 90$^{\circ}$ out-of-phase and of the same phase respectively. Figure 2C shows the waves which result from the difference of the waves of the two amplifier systems at these respective phase angles. It is thus evident that, when the two waves are 180$^{\circ}$ apart, the output voltage wave form has a 50% duty cycle and when the phase angle is 90$^{\circ}$ the widths of the output pulses have decreased. Finally, when the two voltages are in phase, no voltage output appears.

Figure 2D illustrates the resultant current output from the system, after filtration in the T-network filter. The action of the T-network filter results in the energy into the load resistor 40 as being transformed into a sinusoidal voltage and current wave whose amplitude depends upon the width of the square wave energy pulse at the input to the filter network. For example, as indicated in Figure 2D, the amplitude of the sinusoidal output, when the two square wave voltages are $90^{\circ}$ out-of-phase with one another, is indicated as being 0.7, on the basis of 1.0 when the two square wave voltages are $180^{\circ}$ out-of-phase. As a consequence, it is evident that the output sinusoidal oscillations are amplitude modulated as a function of the relative phase differences of the two input square waves. The system thereby directly generates the modulated envelope output oscillations, and does not include a "stage" that can be referred to as a "modulator stage" employing an active device, as in conventional modulation systems. Thus, the system does not employ a modulator stage, and may more properly be referred to as a controlled energy modulation system. The voltage of the square waves of the amplifiers, i.e. the square wave voltages at terminals 30 and 31, are constant. The output current varies, however, with the impressed modulation, which may be audio modulation, so that the energy developed at the output of the system is directly proportional to the value of the current.

In an amplitude modulation system, the power output on modulation peaks of 100% is four times the power output of the carrier with no modulation. In the system described herein the square wave voltage amplitude at the output of the power amplifiers is constant, so that the current variation at the output of the entire system must be proportional to the output energy required. Therefore, the current variation must vary from the carrier value to four times the carrier value on 100% modulation peaks. This requires that the current variation must follow a square law relative to a linear modulation voltage input. In other words if the relative phase of the outputs of the two amplifier systems of Figure 1 is varied by a linear modulation voltage according to a square law, the energy delivered to the output network will vary in accordance with the energy in an amplitude modulated wave. The output network filter thereby is employed to convert the variable energy square wave output into a sine wave modulated envelope of carrier oscillations for application to the load or to a radiating element.

In the system of Figure 1, the circuits for varying the relative phase of the input voltages to the amplifiers have not been illustrated. It will be evident, however, that the control of the relative phase may be effected by maintaining the phase of one of the input voltages constant while varying the relative phase of the other to provide the entire degree of phase variation. Alternately, the relative phase variation may be obtained by a simultaneous variation of the two square wave voltages. In the latter system, it is evident that each of the input voltages need be varied only from 0 to 90$^\circ$, so that the full 180$^\circ$ variation of either of the voltages is not necessary as it is in the arrangement wherein one of the input voltages is held at a constant phase. The latter system prevents incidental phase modulation of the output carrier frequency envelope, and, in fact, will permit an adjustment of balance between the phase shift applied to the two amplifier systems for nulling out any incidental phase modulation.

For proper operation of the system, the load impedance at the output of the output transformer 34 should be resistive at the fundamental carrier frequency which will generally be a radio frequency. Further, the output impedance should have no inductive reactance at all harmonics of the carrier frequency, in order to be able to maintain the square wave voltage at the output terminals of the amplifier systems, as well as at the output of the output transformer itself. It has been found that if the inductive reactance "seen" by the output transformer secondary winding at the third harmonic is approximately 5 to 10 times the value of the resistive component at the fundamental wave, satisfactory square wave voltages and rise times will be cobtained at the output terminals 30 and 31 of the two amplifier systems.

In one example of the invention, the circuit of Figure 1 was constructed employing four type SVT-300-3 transistors. The transmitter was constructed to have about 50 watts output, and variable phase square waves of 1000 KHz were applied to the input terminals 18 and 19. It must be pointed out, of course, that this selection of a carrier frequency is not intended to limit the scope of the invention.

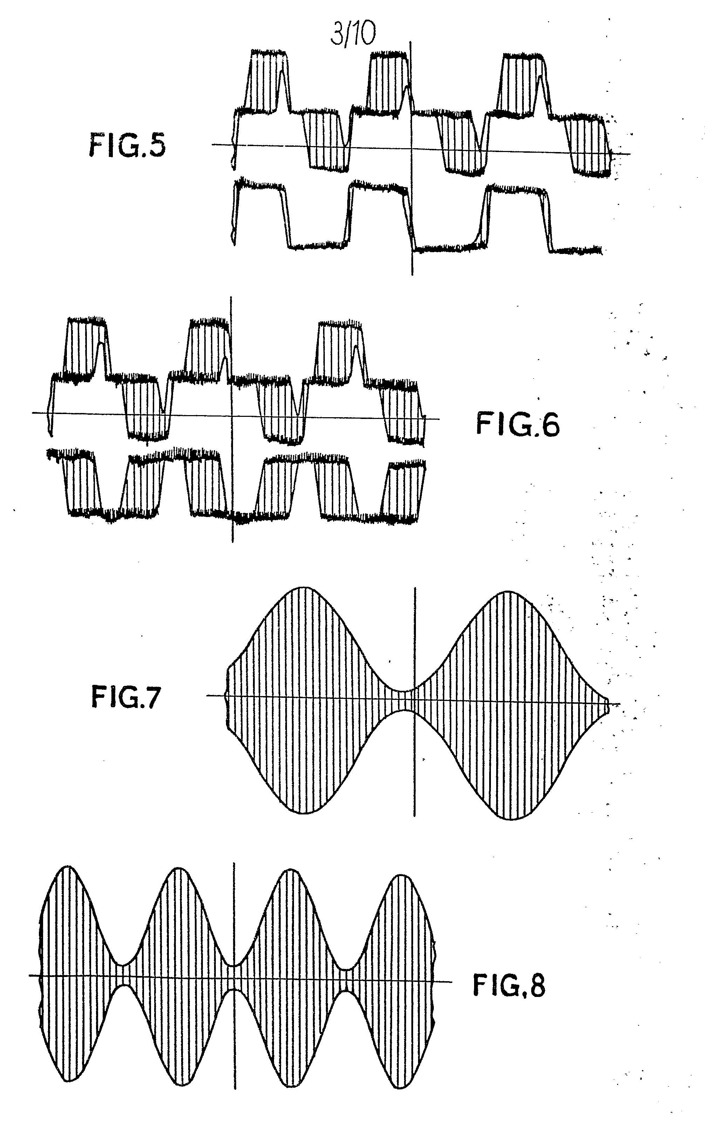

Figure 3 is a photograph in which the lower trace shows the square. waves at the amplifier output terminal 31, and the upper trace shows the square wave at the secondary winding of the output transformer 34. Figure 4 is a photograph in which the lower trace shows the voltage at the output terminal 30, the output voltage of the output transformer being illustrated in the upper trace. The upper trace of these two figures is thus the same, and represents a current pulse width corresponding to approximately carrier level for the 50 watt transmitter.

In Figure 5, the photograph, in the lower trace, shows a square wave at the output terminal 31 of the right hand amplifier system of Figure 1, this lower trace designating the "reference" phase. The upper trace of this figure shows the wave form at the output of the output transformer 34 with approximately 90% modulation at 100 Hz.

The lower trace square wave in Figure 5 illustrates some phase jitter as a result of cross-coupling in an integrated circuit employed in the exciter for the transmitter and is correctable.    Figure 6 is a photograph illustrating, in the lower trace, the variable phase following the modulation, which exists at the output terminal 30, which results in the upper trace wave form of Figures 5 and 6 at the output of the transformer 34 with 90% modulation at 100 Hz.    Figure 7 is a photograph illustrating the modulation envelope at the system output terminal 35, with a 5 Hz sinusoidal wave modulation at about 90%. In this wave, the total harmonic distortion is about 1.2%.    Figure 8 shows the system output wave form with 1000 Hz modulation at about 90% modulation.    In this wave form the total harmonic distortion is about 1%.

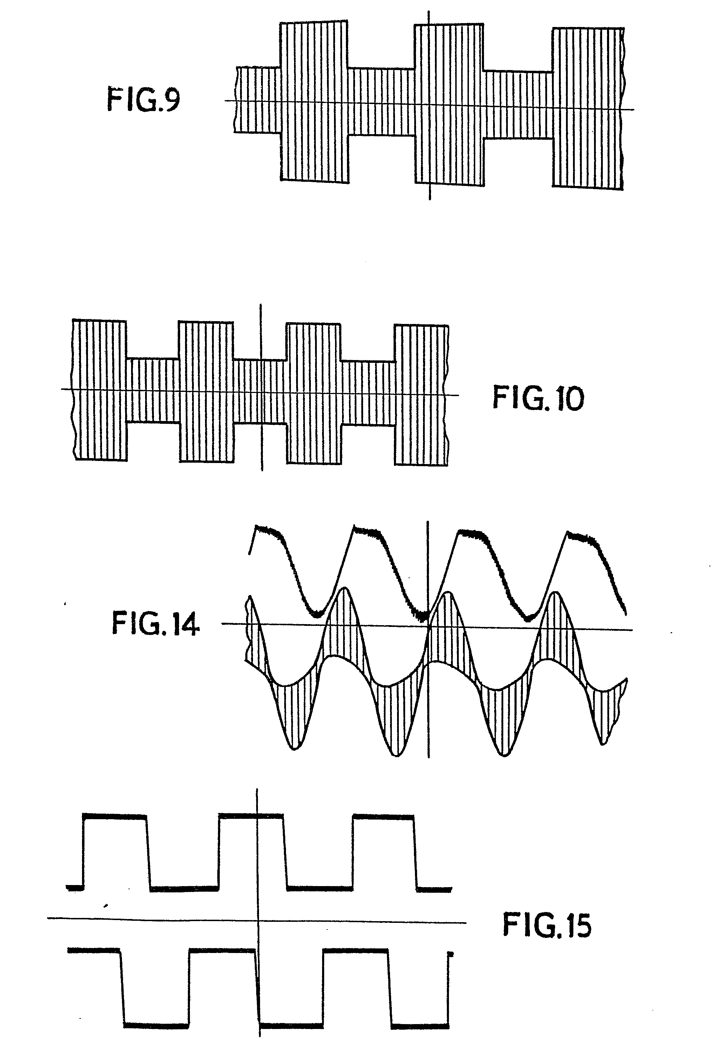

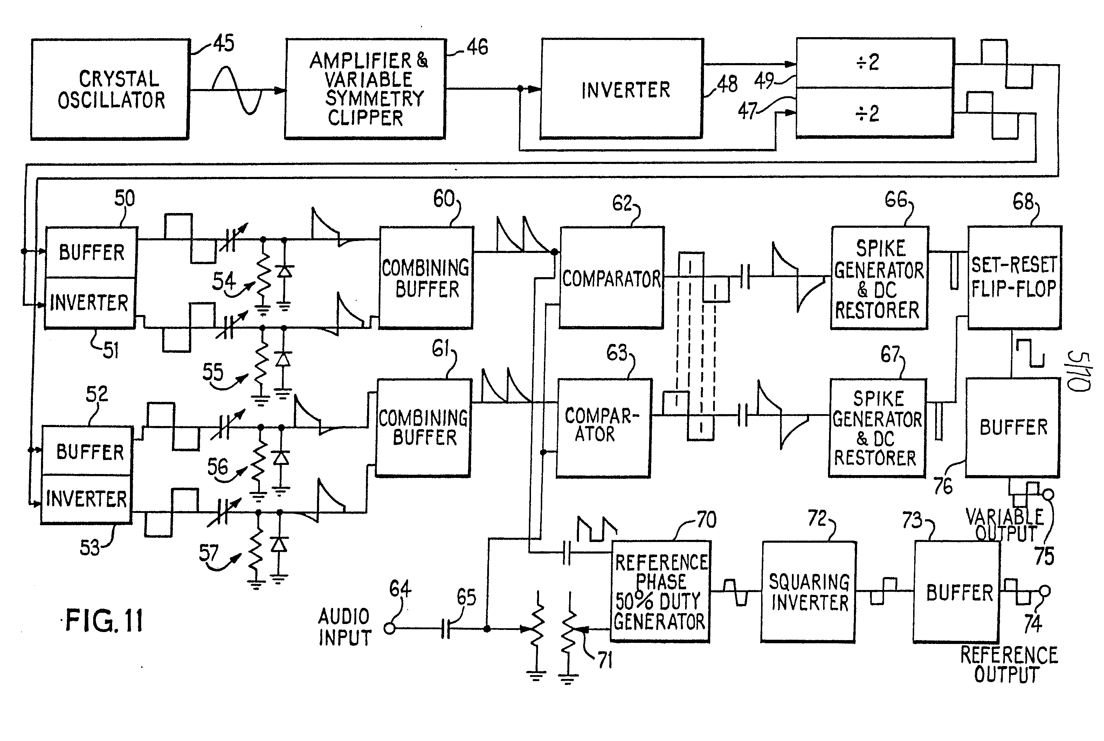

Figure 9 is a photograph illustrating the system output with 50% square wave modulation at 20 Hz.    In this figure, a small degree of tilt is discernable as a result of the position of too small a coupling capacitor employed for the audio signal in the exciter, and this effect is easily correctable.    Figure 10 illustrates the system output with square wave modulation at approximately 50 Hz and 50% modulation.    The tilt is no longer visible under these conditions.    With about 50% modulation with a 5000 Hz square wave signal a similar wave form was obtained although showing a very slight overshoot on the rise and fall times inherent in a broad bandwidth system due to lack of critical damping.

Figure 11 is a block diagram of an exciter that may be employed to produce the variable phase square wave voltages for application to the amplifier system of Figure 1.    While the arrangement of Figure 11 shows a system in which one of the square wave voltage outputs is a reference output, this has been done for the sake of simplicity, and the system may vary the phase applied to

both of the output amplifiers, in opposite directions. As further discussed above, in order for the output amplifier circuits of the system to function in a predictable manner, the drive requirements are that the two input square waves have a 50% duty cycle. There should be a possible phase variation of $180^{\circ}$ between the two square wave voltage inputs to the amplifiers, and in the exciter of Figure 11, this is effected by variation of only one of the square wave voltages. If both of the inputs to the amplifier are varied in phase, then, of course, each one must be varied by a maximum of only $90^{\circ}$ in response to the audio or other input signal. As further discussed above, the phase variation must be in accordance with a square law, relative to linear modulation voltages impressed upon the system.

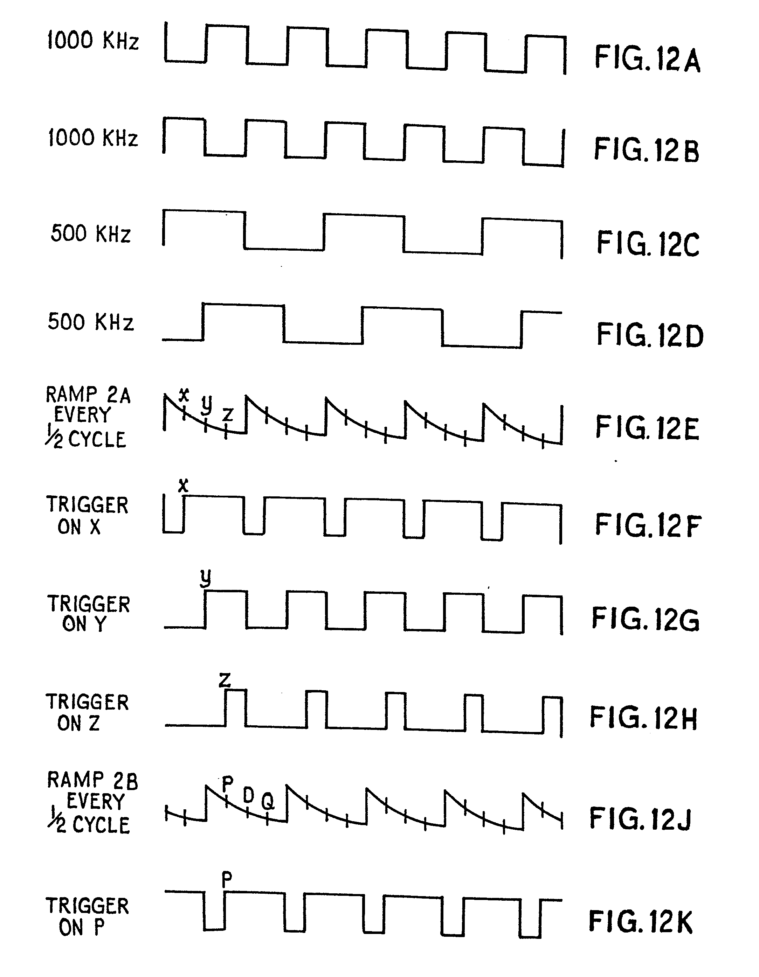

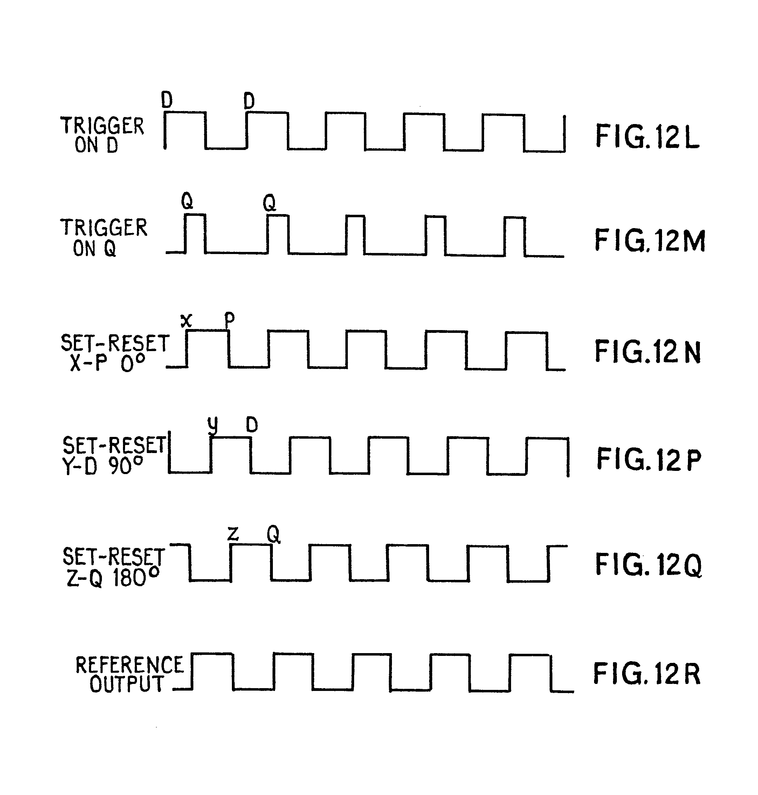

Referring now to Figure 11, therein is illustrated a crystal oscillator 45 of conventional construction producing in the present example, a sinusoidal output of 1000 KHz. The output of the oscillator is amplified and symmetrically clipped in a conventional circuit 46 for this purpose, the square wave output of the clipper being illustrated in Figure 12A. This square wave is applied directly to a divide by two circuit 47, to produce a 500 KHz square wave as illustrated in Figure 12C. The output of the clipper 46 is also applied to an inverter 48, to produce the inverted 1000 KHz wave form as shown in Figure 12B, with this voltage being applied to a divide by two circuit 49 to produce the phase shifted 500 KHz wave form illustrated in 12D.

It will be noted that the two 500 KHz signals have relative phase separation at $90^{\circ}$ at this frequency.

The output of the divider 47 is connected to a buffer 50 and inverter 51 and the output of the divide by two circuit 49 is connected to a buffer 52 and an inverter 53. The output of each of these buffers and inverters is connected to a separate differentiating and dc restoring circuit 54, 55, 56 and 57, each of which may be comprised of a series capacitor, a shunt output resistor and a shunt output dc restoring diode. As a result, the outputs of these latter four circuits are ramp voltages of different phases.

Still referring to Figure 11, the ramp outputs of the dc restorers and differentiators 54 and 55, are combined additively in a combining buffer 60 to produce a ramp on every ½ cycle on the 500 KHz square wave signal, as illustrated in Figure 12E. The ramp outputs of the dc restorers and differentiating circuits 56 and 57 are similarly combined in the combining buffer 61 to produce the ramp signal shown in Figure 12J. The combining buffer circuits 60 and 61 may be comprised of conventional buffers and analog adding circuits.

The outputs of the combining buffers 60 and 61 are applied to one input of the comparators 62 and 63 respectively, and an audio signal from an audio input terminal 64 is applied, by way of a coupling capacitor 65, to the other input of each of the comparators. The comparators 62 and 63 may comprise, for example, trigger circuits with variable thresholds in dependence upon the instantaneous amplitudes of the audio input modulation signals. As a consequence, the output of the comparator circuit 62 may comprise trigger signals having descending flanks at the start of the corresponding ramps, and ascending flanks when the ramps cross the threshold values, as illustrated in Figures 12F - 12H for three different threshold values X, Y and Z. It will be observed that the threshold values corresponding to the audio input voltage, are variable over a range corresponding to $180^O$ of the original 1000 KHz signal. The comparator circuit 63 produces the corresponding trigger signal outputs at the levels P, D and Q, as shown in Figures 12K - 12M.

The outputs of the comparators 62 and 63 are applied, by way of differentiating capacitors, to spike generators and dc restorer circuits 66 and 67 respectively. The outputs of these spike generators are negative trigger pulses that are 180° apart with respect to the original 1000 KHz oscillations. These trigger signals are applied to the set and reset terminals of the flip-flop circuit 68, to produce square wave output voltages having phase conditions dependent upon the threshold levels of the comparator circuits. Thus, when the threshold level derived from the audio input corresponded to the levels X and P of the comparators 62 and 63 respectively, the output square wave has the relative phase position as illustrated in Figure 12N. The variation of the phase position of the output of the flip-flop is shown for the threshold values Y and D in Figure 12P, and for the threshold values Z and Q as shown in Figure 12Q. As a consequence, it is apparent that the output flip-flop signals, with variable phase positions as shown in Figures 12N - 12Q, may be varied through a relative phase difference of 180° with respect to the original 1000 KHz oscillation.

The above technique is advantageous for developing the variable phase signal, since the useful portions of the ramp curves of Figures 12E to 12J vary approximately according to a square law. The shape of these voltages may, of course, be changed by changing the resistor-capacitor time constant in the respective differentiating circuits or by addition of shunt capacitances across the resistors in these differentiating networks.

From the above described system, it will be apparent that if the audio signal is employed to set the threshold value of the comparator, then the modulation signal will shift the phase of the output square wave from the exciter to the necessary 0 to 180° range. The fixed output for the reference phase square wave may be obtained from a number of different points in the system of Figure 11. For example, as illustrated in Figure 11, the output of the combining buffer 60 may be capacitively coupled to a reference phase 50% duty generator, in order to produce a square wave output signal synchronized with a given threshold level of the output ramp of the combining buffer 60. This reference phase generator 70 may be in the form of a comparator similar to the comparators 62 and 63, with a threshold level set by a potentiometer 71 to enable the attaining of a 50% duty cycle. The output of the generator 70 is squared in the squaring inverter 72, and then supplied by way of a conventional buffer 73 to the reference output terminal 74. This reference output is illustrated in Figure 12B. The variable phase output from the flip-flop 68 may, of course, be applied to the variable phase output terminal 75 by way of a conventional buffer 76.

Referring still to Figure 11, the clipper circuit 46 may comprise a squaring amplifier, the term "variable symmetry" referring to the fact that the operating point of transistors employed in this circuit is variable in such a way that the output wave form can have a large on time or a large off time, in order to vary the square symmetry of the output wave. This produces the result that, by varying the symmetry of the output of the clipper, the relative position of the two outputs of the divide by two counters can be controlled. The required position corresponds to a $90^{o}$ phase relationship between the two counter outputs, in accordance with Figures 12C and 12D.

The diodes connected across the outputs of the differentiating networks 54 - 57 clip the negative over-swings on the negative half cycles at each of the input waves. In one example of a circuit embodying the invention, the combining buffers 60 and 61 were comprised of emitter followers, connected in a manner similar to a differential amplifier, to produce the resultant output illustrated in Figures 12E to 12J.

The capacitors connected between the comparators 62 and 63 and the spike generators 66 and 67 effect the differentiating of the output of the comparators to provide relatively sharp positive going spikes. The spike generators may comprise transistor amplifiers, with diodes connected between the bases and ground to restore the dc level to the positive going halves of the spikes, and to clip off the negative halves. This reuslts in the production of the spikes as illustrated in Figure 11 at the output of the generators 66 and 67. The relative positions of the spikes from the spike generators 66 and 67, with proper setting of the circuit, thus, always correspond to 180$^O$ with respect to the original 1000 KHz oscillator wave form.

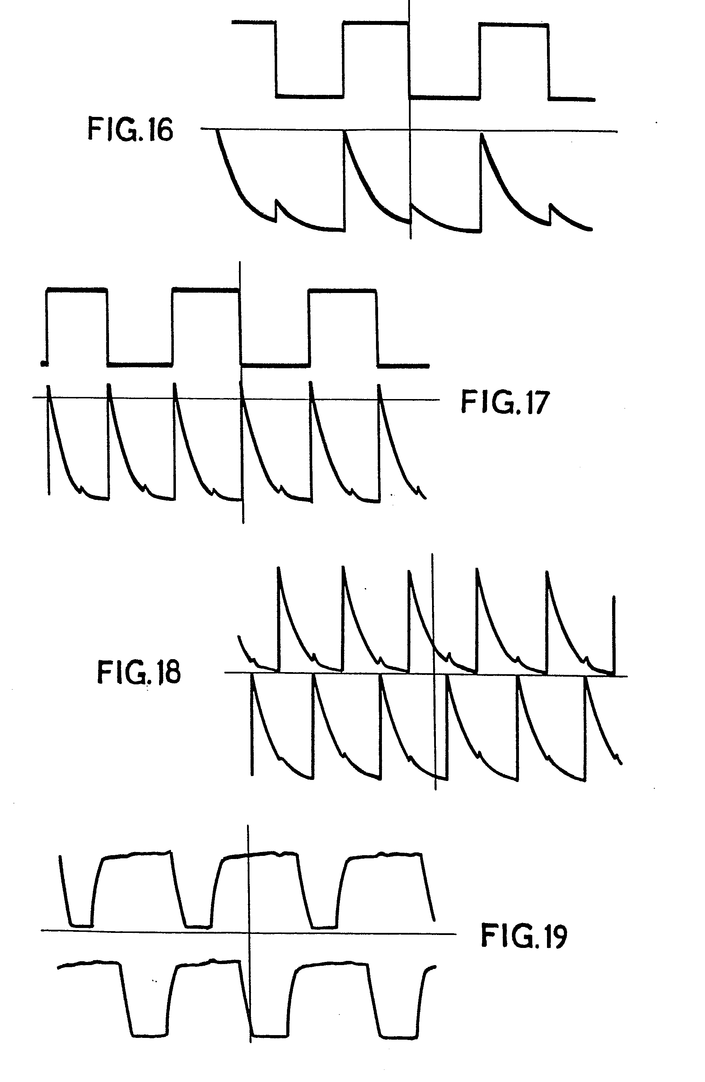

Figures 14 to 21 are oscillograms showing the wave forms produced in an actual embodiment of the exciter circuit of Figure 11. Thus, the upper trace on Figure 14 shows the output of crystal oscillator at 3 volts peak-to-peak at 1000 KHz. The lower trace is the output of the 50 watt transmitter at a dummy load, with about 90% modulation. Figure 15 shows the two outputs from the divide by two counters 47 and 49 spaced 90$^O$ with respect to one another. The upper trace of Figure 16 shows one of the counter outputs at 500 KHz and the lower trace shows the output of the following differentiating network.

Figure 17 shows the 500 KHz counter output compared to the output from the combining buffer illustrated in the bottom trace. Figure 18 shows the outputs from the two combining buffers, illustrating the 90$^O$ relative spacing.

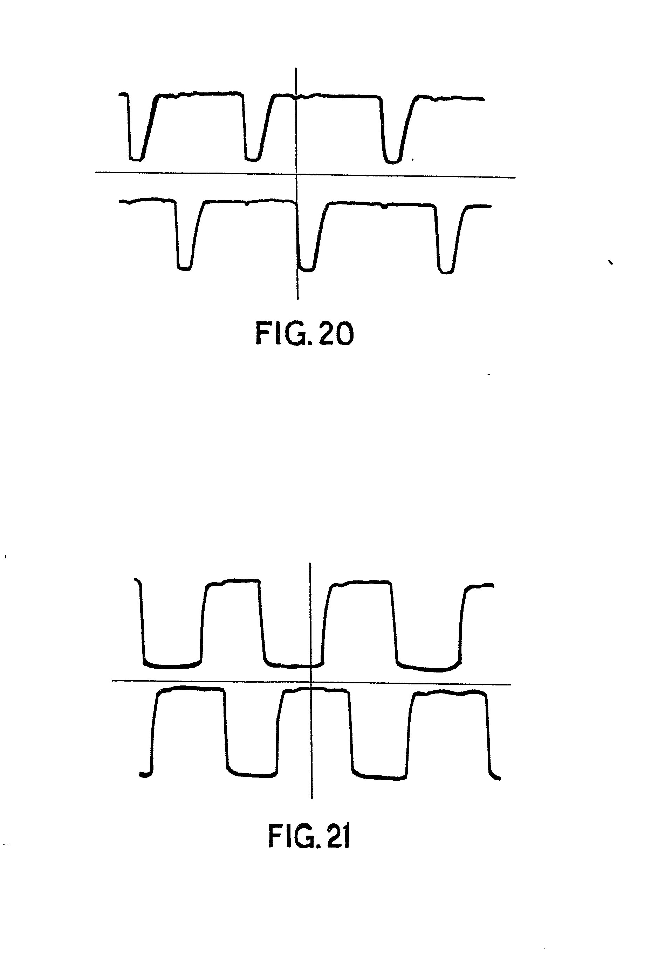

Figure 19 shows the outputs from the comparators 62 and 63, and Figure 20 shows the outputs of the two spike generators.

In Figure 21, the upper trace is the reference output at terminal 74, set to approximately 50% duty factor, while the lower trace shows the variable phase output.   While some of the curves do not have the ideal 50% duty cycle, this is a matter of adjustment of the circuits, and the results obtained with an exciter showing the traces as illustrated in these figures, were quite satisfactory.

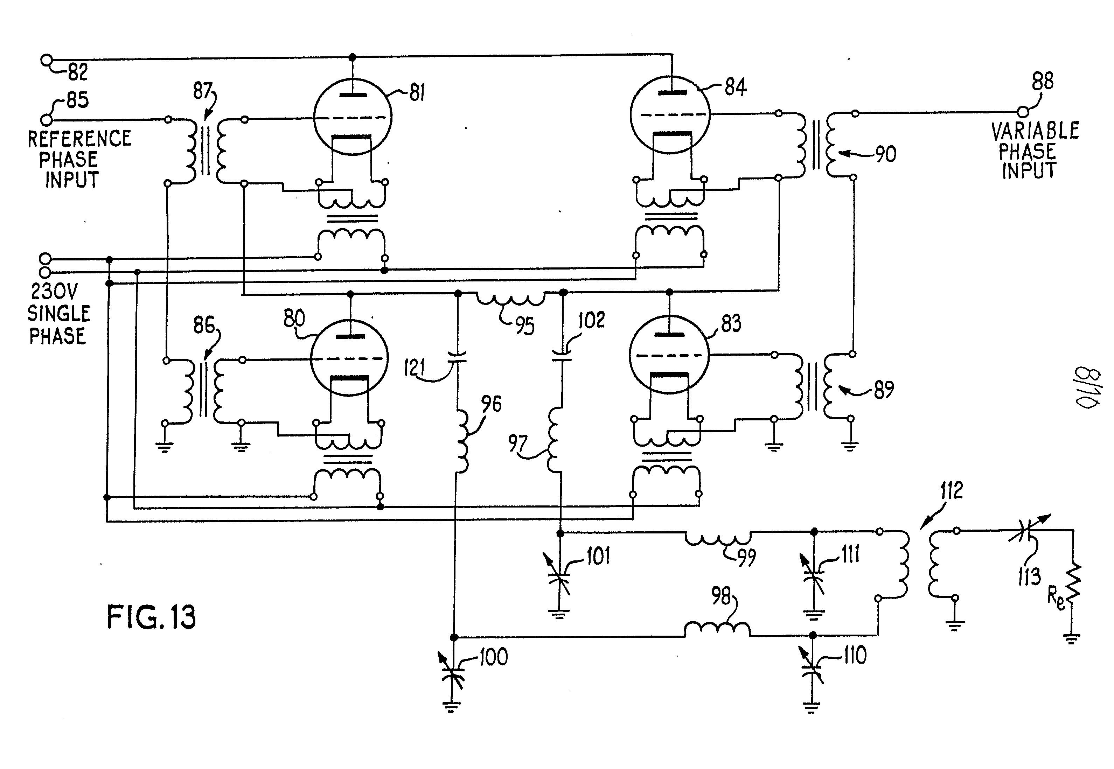

Figure 13 shows a circuit embodying the invention, wherein vacuum tubes have been employed for the switching and amplifying devices.   In this arrangement, the vacuum tubes are preferably zero bias triodes, but, it will, of course, be apparent that the circuit  may alternatively employ triodes which require bias on their control grids, or alternatively, with tetrodes having suitable voltages applied to their screen grids.   The power output of the circuit, of course, depends upon the type of tube selected. The exciter system, as described with reference to Figure 11, may be employed either in combination with the transistor circuit of Figure 1, or the tube circuit of Figure 13, for the production of an output of any desired power, it being, of course, required that the output buffer amplifiers of the exciter be designed to provide the necessary input drive voltage required by the selected tube or transistor.

In the circuit of Figure 13, the cathode-anode circuits of the triodes 80 and 81 are serially connected between ground reference and the positive supply terminal 82, and similarly the cathode-anode current paths of the triodes 83 and 84 are serially connected between ground reference and the positive supply terminal 82.   The reference phase input at terminal 85 is applied by way of coupling transformers 86 and 87 to the grids of the triodes 80 and 81 respectively, and similarly the variable phase square wave input at terminal 88 is applied by way of coupling transformers 89 and 90 to the control grids of the triodes 83 and 84 respectively.

Suitable separate filament transformers are provided for the tubes, as illustrated, the secondary windings of the filament transformers having centre taps for the cathode-anode current of the tubes.

While the circuit of Figure 13 may employ a common output transformer, as in the arrangement of Figure 1, Figure 13 illustrates a different output circuit which, of course, could alternately have been employed in the arrangement of Figure 1. In place of the primary winding of the output transformer as shown in Figure 1, in Figure 13 a suitable impedance in the form of a radio frequency choke 95 is connected between the anodes of the triodes 80 and 83 for carrying the dc current. The load for the amplifier comprises a balanced T-network of input inductors 96 and 97, the output inductors 98 and 99, and shunt capacitors 100 and 101 respectively, with each of these T-networks being connected to a separate end of the inductor 95. For this latter connection, blocking capacitors 121 and 102 are provided, in order to isolate the dc voltage from the output network. Alternatively, if a coupling transformer had been used, it is apparent that the T-networks could have been connected to the separate secondary windings of the coupling transformer. Shunt capacitors 110 and 111 are connected at the outputs of the T-networks and an output transformer 112 has its primary winding connected between the outputs of the T-networks. A load, illustrated as a resistive load $R_1$ is coupled to the secondary winding of the transformer 112 by way of capacitors 113. The primary winding of the transformer 112 and the shunt capacitors 110 and 111 form a high Q tank circuit, which, by inductive coupling to the load $R_1$ through the output transformer 112 and series resonating capacitors, places a termination load at the output of the balanced T-network and this load is reflected to the proper value for loading the power amplifiers at the input of the T-networks.

It is, of course, apparent that the input transformers 86, 87, 89 and 90 are wide band high frequency transformers; these transformers delivering the drive signal to the control grids of the amplifier tubes.

While other input and output circuits may, of course, be employed, it is important that the load in the output circuit be as nearly purely resistive as possible. At odd harmonic frequencies, the load must be presented to the tubes as an inductive reactance.

As compared with previous arrangements, the present invention has a principal advantage of increased power conversion efficiency. Since the power amplifier output is a constant voltage square wave, the current flow at any modulation index occurs only during the flat minimum voltage across the active devices. As a consequence, the active devices are required to dissipate much less power, and can have lower power ratings. From this, it of course follows that lower power is required for the cooling requirements of the active devices.

A further advantage of the system of the invention resides in the elimination of any type of modulator stage to impress modulation on a final amplifier. This not only increases the reliability of the system by the reduction of the number of parts in the transmitter, but also eliminates losses associated with such modulators, thereby providing a further substantial increase in overall efficiency.

Further, in a circuit arrangement embodying the invention, there is no necessity for direct coupling or clamping or dc restoration after ac coupling, to transmit dc information, given the employment of perfect square waves. The system of the invention employs symmetrical waves as opposed to rectangular waves which have shifting base line or axis asymmetry.

In an arrangement in accordance with the invention, there is in addition, no requirement for clamping of any back-swing voltage, since the upper and lower devices in the amplifier means, or "totem poles" are active on alternate half-cycles.

The output transformer or output circuit, as the case may be, receives a pulse every half cycle of the r-f carrier frequency, rather than one pulse per cycle as in conventional single ended output circuits. This renders the filtering of the output much easier since the output wave form contains no even harmonics.

Although the invention has been described in regard to a radio transmitter embodiment feeding a modulated carrier signal to an antenna and, thus, employed powerful amplifier circuits, it is understood that the practice of the invention need not require such amplifiers. For example, for a lower power application, square wave signals of suitable power content could be applied directly (with the proper coupling) to the output transformer 34 in Figure 1.

- 1 -

CLAIMS

1.      An electronic circuit arrangement for generating modulated oscillations comprising generating means
for generating two separate square wave signals at a
carrier frequency, means for varying the relative phase
between the said square wave signals in accordance with
a modulating signal, and an output circuit coupled to
receive said square wave signals and provide an output
dependent on the relative phase therebetween.

2.      The circuit arrangement as claimed in Claim 1
in which the means for varying the relative phase between
the said square wave signals operates to vary the relative
phase as a square law function of the modulating signal.

3.      The circuit arrangement as claimed in either
one of the preceding claims and including two amplifier
circuits for amplifying the said respective square wave
signals and in which the said output circuit is connected
to both of said amplifier circuits to receive a signal
proportional to the difference between the outputs of the
said amplifier circuits.

4.      The circuit arrangement as claimed in Claim 3
in which each of the said amplifier circuits comprises a
pair of switching devices having serially connected outputs
and means applying one of the square wave signals to said
devices in phase opposition whereby the interconnected
switching devices are alternately conductive.

5.      The circuit arrangement as claimed in Claim 4
in which the said output circuit includes impedance means
connected between the serial interconnections of the
switching devices in the respective amplifier circuits.

6.      The circuit arrangement as claimed in Claim 5
in which the said impedance means comprises the primary
winding of a transformer.

7.      The circuit arrangement as claimed in Claim 6
in which the said output circuit includes a low-pass
filter connected to a secondary winding of the said transformer and arranged to pass oscillations at the carrier frequency.

8. The circuit arrangement as claimed in Claim 7 in which the said low-pass filter is a T filter.

9. The circuit arrangement as claimed in any one of Claims 6 to 8 in which antenna means are coupled to a secondary winding of the said transformer to enable oscillations at said carrier frequency to be radiated.

10. The circuit arrangement as claimed in any one of Claims 4 to 9 in which the said switching devices are transistors.

11. The circuit arrangement as claimed in any one of Claims 4 to 9 in which said devices comprise thermionic tubes.

12. The circuit arrangement as claimed in any one of Claims 1 to 11 in which the means for varying the relative phase between the square wave signals operates to vary the phase of one of said signals while the phase of the other of said signals is maintained constant.

13. The circuit arrangement as claimed in Claim 12 in which the generating means includes means for generating two trains of ramp signals at the carrier frequency but displaced from each other by half the carrier period and in which the phase varying means includes two comparators in each of which a respective ramp signal train is compared with a modulating signal to generate a trigger pulse when the instantaneous value of the modulating signal exceeds the instantaneous value of the ramp signal, the respective trigger pulses from the comparators being used to define the start and finish of the square waves of the said one of said square wave signals.

14. The circuit arrangement as claimed in Claim 13 in which the means for generating two trains of ramp signals comprises means for generating a pair of square wave signals at half the carrier frequency and displaced from each other by half the carrier period and means for providing ramp signals in each half cycle of the said pair of square wave signals.

15. The circuit arrangement as claimed in Claim 14 in which the means for generating a pair of square wave signals at half the carrier frequency comprises an oscillator for generating a single square wave signal at the carrier frequency and two divide-by-two circuits arranged to be fed respectively with said square wave signal and with said square wave signal inverted.

16. The circuit arrangement as claimed in any one of Claims 13 to 15 in which the slopes of the ramps of said ramp signals have a square law characteristic.

17. A method of generating modulated oscillations comprising the steps of generating two separate square wave signals at a carrier frequency, varying the relative phase between said signals in accordance with a modulating signal, and combining said signals of variable relative phase in a manner such that the resultant output signal has an amplitude which is a function of the said relative phase.

18. The method as claimed in Claim 17 in which the relative phase is varied as a square law function of the modulating signal.

19. The method as claimed in Claim 17 or Claim 18 and including the steps of converting the resultant output signal to a sine wave signal.

20.     The method as claimed in Claim 19 in which the said converting step comprises applying the resultant output signal to a low-pass filter arranged to pass signals at the carrier frequency.

21.     The method as claimed in any one of Claims 17 to 20 and including the step of amplifying the variable phase square wave signals by applying each of said signals to a respective pair of serially connected switching devices in phase opposition.

22.     The method as claimed in Claim 21 in which the said step of combining the said signals comprises applying the outputs at the serial interconnections between the switching devices to opposite ends of an impedance means and deriving the resultant output signal from the voltage across the said impedance means.

23.     The method as claimed in Claim 22 in which the said impedance means comprises the primary winding of a transformer.

24.     A modulated oscillatory signal generated by the method claimed in any one of claims 17 to 23.

25.     An electronic circuit arrangement for generating modulated oscillations characterised in that it comprises means for combining two separate square wave signals at a carrier frequency and of varying relative phase and for providing an output depending on such relative phase.

FIG.1

2/10

FIG.2A

FIG.2B

FIG.2C

FIG.2D

FIG.3

FIG.4

FIG.5

FIG.6

FIG.7

FIG.8

3/10

0011464

4/10

**FIG.9**

**FIG.10**

**FIG.14**

**FIG.15**

FIG.11

CRYSTAL OSCILLATOR — 45

AMPLIFIER & VARIABLE SYMMETRY CLIPPER — 46

INVERTER — 48  49  ÷2

47  ÷2

BUFFER / INVERTER — 50 / 51

54  55

BUFFER / INVERTER — 52 / 53

56  57

COMBINING BUFFER — 60

COMBINING BUFFER — 61

COMPARATOR — 62

COMPARATOR — 63

SPIKE GENERATOR & DC RESTORER — 66

SPIKE GENERATOR & DC RESTORER — 67

SET-RESET FLIP-FLOP — 68

BUFFER — 76

VARIABLE OUTPUT — 75

AUDIO INPUT — 64  65

71

REFERENCE PHASE 50% DUTY GENERATOR — 70

SQUARING INVERTER — 72

BUFFER — 73

REFERENCE OUTPUT — 74

5/10

0011464

1000 KHz **FIG. 12A**

1000 KHz **FIG. 12B**

500 KHz **FIG. 12C**

500 KHz **FIG. 12D**

RAMP 2A
EVERY
½ CYCLE
x y z **FIG. 12E**

TRIGGER
ON X
x **FIG. 12F**

TRIGGER
ON Y
y **FIG. 12G**

TRIGGER
ON Z
z **FIG. 12H**

RAMP 2B
EVERY
½ CYCLE
P D Q **FIG. 12J**

TRIGGER
ON P
P **FIG. 12K**

TRIGGER
ON D
D D

**FIG.12L**

TRIGGER
ON Q
Q Q

**FIG.12M**

SET-RESET
X-P 0°
X P

**FIG.12N**

SET-RESET
Y-D 90°
y D

**FIG.12P**

SET-RESET
Z-Q 180°
z Q

**FIG.12Q**

REFERENCE
OUTPUT

**FIG.12R**

FIG.13

FIG.16

FIG.17

FIG.18

FIG.19

FIG. 20

FIG. 21